# EUROPÄISCHE PATENTSCHRIFT

(11) **EP 1 611 619 B1**
(45) Veröffentlichungstag und Bekanntmachung des Hinweises auf die Patenterteilung: **02.01.2013**
(21) Anmeldenummer: 04725878.5
(22) Anmeldetag: 06.04.2004
(51) Int. Cl.: H01L 33/00

(54) **LEUCHTSTOFFBASIERTE LED UND ZUGEHÖRIGER LEUCHTSTOFF**
LUMINOPHORE-BASED LED AND CORRESPONDING LUMINOUS SUBSTANCE
LED A BASE D'UN MATERIAU FLUORESCENT ET MATERIAU FLUORESCENT CORRESPONDANT

(30) Priorität: 10.04.2003 DE 10316769
(43) Veröffentlichungstag der Anmeldung: 04.01.2006
(73) Patentinhaber: Osram AG, 81543 München (DE); OSRAM Opto Semiconductors GmbH, 93055 Regensburg (DE)
(72) Erfinder: BRAUNE, Bert, 93173 Wenzenbach (DE); BRUNNER, Herbert, 93161 Sinzing (DE); JERMANN, Frank, 81739 München (DE); ZACHAU, Martin, 82269 Geltendorf (DE)
(74) Vertreter: Raiser, Franz
(86) Internationale Anmeldenummer: PCT/DE2004/000722
(87) Internationale Veröffentlichungsnummer: WO 2004/093203

(56) Entgegenhaltungen:
- EP-A- 1 074 603
- WO-A-01/08452
- WO-A-01/08453
- WO-A-97/50132
- WO-A-98/12757
- WO-A-03/028061
- US-A1- 2003 017 264
- US-A1- 2003 032 192

## Beschreibung

### Technisches Gebiet

Die Erfindung betrifft eine Leuchtstoffbasierte LED und zugehöriger Leuchtstoff gemäß dem Oberbegriff des Anspruchs 1. Es handelt sich dabei insbesondere um weiße oder farbige Lumineszenzkonversions-LEDs mit blau oder UV emittierenden Primärstrahlern. Mit dem Begriff LED sind hier immer LEDs mit anorganischen Leuchtstoffen gemeint.

### Stand der Technik

Aus der WO 02/089 175 ist bereits eine Leuchtstoffbasierte LED und zugehöriger Leuchtstoff bekannt, bei der die UV-Strahlung der primäremittierenden Quelle von einem Leuchtstoff konvertiert wird. Um den Austritt von UV-Strahlung aus der LED zuverlässig zu verhindern, wird zusätzlich ein hoch UV-streuendes Material, das aber nicht Konversionseigenschaften haben darf, verwendet. Um diese Eigenschaft zu erreichen, kommt es weniger auf das Material an, als darauf, dass die Partikelgröße des UV-streuenden Materials möglichst klein ist und sein Durchmesser im Bereich einiger Nanometer liegt. Dabei wird also ein zusätzliches Material (Diffusor) neben dem Leuchtstoff im Harz benötigt. Auch Halo- und Penumbraeffekte werden dadurch vermieden.

Ein ganz ähnliches LED-System, jedoch ganz ohne Leuchtstoff, wird generell zur Reduzierung von Streuverlusten (Fresnel-Verluste) der emittierenden Lichtquelle in der US 5 777 433 beschrieben.

Aus der EP 1 074 603 ist die Herstellung eines oxidischen Leuchtstoffs mit Partikelgröße im Nanometerbereich beschrieben. Als Anwendungsgebiet ist beispielsweise das Gebiet der LEDs oder OLEDs angegeben.

In der US 6 207 229 ist ein lumineszierendes Halbleiterkristall vom Typ CdX mit X = S, Se, Te zur Verwendung in LEDs beschrieben. Er ist mit einem Überzug vom Typ ZnY mit Y= S, Se versehen. Aus der GB-A 2 389 230 ist ein LED bekannt, das eine Schicht aus CdS in Nanopartikel-Größe verwendet.

### Darstellung der Erfindung

Es ist Aufgabe der vorliegenden Erfindung, eine Leuchtstoff-basierte LED gemäß dem Oberbegriff des Anspruchs 1 bereitzustellen, die sich durch höhere Effizienz und Gleichmäßigkeit der Lichtabstrahlung auszeichnet.

Diese Aufgabe wird durch die kennzeichnenden Merkmale des Anspruchs 1 gelöst. Besonders vorteilhafte Ausgestaltungen finden sich in den abhängigen Ansprüchen.

Die bisher in Lukoleds verwendeten Leuchtstoffe haben Korngrößen > 1 µm. Das von der Primär-LED emittierte Licht wird nicht vollständig von den Leuchtstoffkörnern absorbiert, sondern zum Teil reflektiert. Über einfache oder mehrfache Reflexionen fällt das anregende Licht der Primär-LED teilweise auf den Chip oder das Gehäuse und wird nichtstrahlend absorbiert. Das heißt die Reflexion an den Leuchtstoffkörnern führt zu einem Lichtverlust. Ein erstes Problem ist, den Lichtverlust durch Reflexion zu mindern. Das gleiche gilt, wenn auch in vermindertem Umfang, für das von den Leuchtstoffkörnern emittierte Licht. Auch dies führt zu Verlusten. Selbst bei den heute verwendeten gut absorbierenden Leuchtstoffen, die nur wenig reflektieren, liegen diese Verluste heute in der Größenordnung von 30%.

Wenn die Absorption eines Leuchtstoffs schwach und seine Reflexion stark ist, führen diese Mehrfachreflexionen dazu, dass das anregende Licht der Primär-LED selbst bei extremer Erhöhung der Leuchtstoffkonzentration nur wenig vom Leuchtstoff absorbiert wird, sondern zum größten Teil nichtstrahlend verloren geht oder am Leuchtstoff vorbei emittiert wird. In diesem Fall sind die Verluste durch die Reflexionen so groß, dass solche Leuchtstoffe heute nicht verwendet werden können, auch wenn ihre Quantenausbeuten sehr hoch sind.

Im Falle der blauen Primär-LED, hat die LUKOLED bei kleinsten Leuchtstoffkonzentrationen immer annähernd die blaue Farbe der Primär-LED. Bei einem gut absorbierenden Leuchtstoff mit schwacher Reflexion kann durch Erhöhung der Konzentration des Leuchtstoffs die Strahlung der blauen Primär-LED weitgehend unterdrückt werden, so dass die LUKOLED annähernd die Farbe der Leuchtstoffemission hat. Bei schwach absorbierenden Leuchtstoffen bleibt die Farbverschiebung auch bei höchsten Leuchtstoffkonzentration nur klein. Der mit schwach absorbierenden Leuchtstoffe überdeckbare Farbbereich ist also viel zu klein.

Allgemein gilt: Je größer die Reflexion der Leuchtstoffe, desto höher sind die Helligkeitsverluste und desto geringer ist der einstellbare Farbbereich einer LUKOLED.

Im Falle der UV-Primär-LEDs verstärkt die Reflexion der UV-Strahlung von den Leuchtstoffkörnern auf das Gehäuse die Alterung des Gehäuses, die heute eines der größten Hürden für die Einführung von UV-LEDs ist.

Ein zusätzliches Problem bisher ist die Sedimentation von Leuchtstoffen im Harz, die zu Inhomogenitäten in der Leuchtstoffverteilung und zu starken Schwankungen der Leuchtstoffverteilung im Harz von LED zu LED führt. Dies führt zu Fertigungsproblemen und auch zu winkelabhängiger Farbe der Lukoleds.

Das Sedimentationsproblem wurde bisher durch kleine Korngrößen des Leuchtstoffs von typisch einigen Mikrometern (µm) gelöst (EP 907 969). Zur Reduzierung der Winkelabhängigkeit der Farbe der Lukoleds wurde vorgeschlagen, den Leuchtstoff konform direkt um den Chip zu verteilen (US 6 351 069).

Die Lösung beider Probleme liegt in der Verwendung von nanoskaligen Leuchtstoffen. Bei Korngrößen im Bereich von circa 0,2 bis 0.5 µm ist die Streuung der Leuchtstoffkörner maximal. Sinken die Korngrößen weiter, wird die Streuung wieder geringer, bis bei Korngrößen von etwa 20 nm und weniger die Streuung vernachlässigbar klein ist. Dies sieht man zum Beispiel daran, dass Suspensionen mit diesen Leuchtstoffen klar und perfekt transparent sind. Daher sind Korngrößen im Bereich 1 bis 50 nm geeignet. Die Lösung der Aufgabenstellung ist dementsprechend eine sog. Lumineszenzkonversions-LED (LUKOLED), wobei die LED primäre Strahlung im Bereich 300 bis 470 nm emittiert, wobei diese Strahlung teilweise oder vollständig in längerwellige Strahlung konvertiert wird durch mindestens einen Leuchtstoff, der der primären Strahlung der LED ausgesetzt ist. Ein entscheidender Punkt ist, dass die Konversion zumindest unter Zuhilfenahme eines Leuchtstoffs, dessen mittlere Partikelgröße d50 im Bereich 1 bis 50 nm, bevorzugt 2 bis 20 nm, liegt, erreicht wird.

Bei den hier angesprochenen Lukoleds handelt es sich um Dioden, die primäre Strahlung aufgrund des Anlegens einer niedrigen Spannung von typisch 1 bis 5 V emittieren. Dabei ist über dem eigentlichen Chip, der an zwei Elektroden angeschlossen ist, eine Leuchtstoff-haltige Schicht aufgebracht. Diese Schicht enthält neben den Leuchtstoff-Partikeln ein isolierendes Polymer. Der Leuchtstoff wandelt zumindest teilweise das vom Chip emittierte Strahlung aufgrund seiner Photolumineszenz-Eigenschaft in Strahlung um, die eine größere Wellenlänge hat als die primäre Strahlung des Chips.

Im Gegensatz dazu sind bekannte Nanopartikel-LED wie sie im Stand der Technik zu finden sind, ganz anders aufgebaut. Die Abkürzug LED steht hier eigentlich für light emitting device, wenngleich es teilweise fälschlich auch als light emitting diode verstanden wird. Jedoch ist ein derartiges Gerät eigentlich keine Diode, sondern ein elektrolumineszierendes Gerät (englisch als ELD (electroluminescent device) abgekürzt. Typisch dafür ist, dass der Leuchtstoff in einer dünnen Schicht zwischen zwei Elektroden angeordnet ist und in einem leitenden Polymer eingebettet ist. dieses vermittelt dann die Leitung zum Leuchtstoff. An den beiden Elektroden liegt eine relativ hohe Spannung von mindestens 20 V an. Die Anforderungen an Leuchtstoffe für derartige Geräte sind nicht vergleichbar mit denen für Leuchtstoff für Lukoleds.

Folgende Vorteile bei Lukoleds lassen sich durch Reduzierung der Streuung mit nanoskaligen Leuchtstoffen erzielen:
- Erhöhung der Helligkeit heutiger LEDs um bis zu 30% durch Reduzierung/Vermeidung der Reflexionsverluste.
- Verwendungsmöglichkeit vieler nur schwach absorbierender Leuchtstoffe, die hohe Quantenausbeuten haben.
- Erweiterung des über die Konzentration der Leuchtstoffe einstellbaren Farbbereichs
- Reduzierung der unerwünschten kurzwelligen Strahlung, so dass nur ein geringer Rest den Bereich der Konversion verlässt: dieser Aspekt ist in zweierlei Hinsicht vorteilhaft: (1) Gehäuse-Alterung, insbesondere bei UV-LEDs, wird drastisch reduziert; (2) es tritt keine kurzweilige, für den menschlichen Organismus schädliche Strahlung (vor allem UV) mehr aus der LED-Oberfläche aus.

Speziell geeignete Systeme verwenden eine primär UV-Strahlung emittierende LED (Peakwellenlänge im Bereich 330 bis 410 nm) zusammen mit einem RGB-System. Als Leuchtstoff-Komponente eignet sich beispielsweise SCAP:Eu für die Emission im Blauen, rot emittierende Nitride für den roten Spektralbereich und Strontium-Aluminat-Leuchtstoffe für grün. Nachfolgend ist eine Reihe von geeigneten Leuchtstoff-Systemen zusammengefasst.
1. SCAP:Eu (blau)
2. SCAP:Eu, Mn (blau, blau-grün, grün, weiß)
3. SrMgA110O17:Eu (SAE, blau)
4. BAM:Eu (blau) und BAM:Eu, Mn (blau, blau-grün, weiß)
5. Sr-Aluminate:Eu und Sr-Aluminate:Eu,Mn. Konkret SrAI2o4, Sr4AI14O25. Alle mit Eu und Eu,Mn-Version, alle möglicherweise zusätzlich mit teilweiser Ba, Ca-Substitution für Sr (alle blau, blau-grün, grün)
6. Sr2SiO4:Eu auch mit teilweiser Ba,Ca-Substitution für Sr. Dieser Leuchtstoff funktioniert für UV-LED besonders gut (grün, gelb, orange)
7. YBO3:Ce,Tb (grün), allgemein Ln=La,Gd für Y oder Mischungen daraus
8. Y2SiO5:Ce,Tb (grün), allgemein Ln=La,Gd für Y oder Mischungen daraus
9. ZnS:Ag (blau), ZnS:Cu, ZnS:Cu,Al (grün) notfalls CdZnS:Cu,Al; außerdem ZnS:Cu,Mn ist grüne Alternative zu ZnS:Cu,Al und ZnS:Cu
10. Y2O2S:Eu allgemein Ln2O2S:Eu mit Ln=La,Gd für Y oder Mischungen daraus (rot). Auch mit Kodotierung von Bi.
11. SrS:Eu - (rot)
12. rot emittierende Nitride

Weitere spezielle Ausführungsformen sind Leuchtstoffe, bei denen je nach Anregungswellenlänge der LED und Absorptionsspektrum des Leuchtstoffs die Peakwellenlänge der UV-emittierenden LED in der Nähe der Absorptionskante der Leuchtstoffe liegt und die deswegen die anregende Strahlung der UV-LED nicht stark absorbieren. Das ist heute bei sehr vielen Leuchtstoffen der Fall, da man möglichst langwellige UV Primär-LEDs verwendet, bei deren Emissionsbereich viele Leuchtstoffe gerade anfangen zu absorbieren. Beispiele sind die o.g. Leuchtstoffe 1,2,4,5,7, und 10 aus obiger Liste,

Eine weitere spezielle Ausführungsform ist ein gelb emittierender Leuchtstoff ("Y") in Kombination mit einer blau emittierenden LED ("B"). Unter dem gelb emittierenden Leuchtstoff sind dabei auch solche System zu verstehen, bei denen mindestens 90 % der Strahlungsanteile an der Leuchtstoffbedingten Emission von einem hauptsächlichen Konverter und der Rest von Zusatzkonvertem stammt, die lediglich dazu dienen, den Farbort zu optimieren.

Konkrete Beispiele für ein BY-System sind blaue InGaN-Chips in Verbindung mit einem der folgenden Leuchtstoffe als Hauptkomponente
1. YAG:Ce und andere Granate;
2. Sr2SiO4:Eu, wie oben. Bereits ausgeführt;
3. Halbleitende nano-Materialien.

Eine weitere bevorzugte Ausführungsform ist ein dotierter Leuchtstoff, der zwar bei hoher Konzentration der Dotierung durch einen Aktivator starke Absorption zeigt, bei dem jedoch nun auch eine geringere Absorption durch eine erheblich reduzierte Konzentration des Aktivators eingestellt werden kann. Im allgemeinen kann dies durch eine Aktivatorkonzentration erreicht werden, die im Bereich von 1 bis 50 % der üblichen bisher bei Leuchtstoffen für LEDs, insbesondere weißen LEDs, verwendeten Aktivatorkonzentration liegt. Ein konkretes Ausführungsbeispiel ist die Gruppe der Seltene Erden-Granate, die bei LEDs häufig verwendet werden. Deren hohe Absorption führte bisher dazu, dass Farborte in der Nähe des Farborts des reinen Leuchtstoffs nicht erreicht werden konnten. Beispielsweise kann nano-YAG:Ce oder nano-TbAG:Ce verwendet werden. Die übliche Ce-Konzentration ist hier 1 bis 5 mol-% des Seltene Erden-Anteils. Mit der nano-Technologie werden auch Konzentrationen bis hinab zu etwa 0,1 bis 1 mol-% nutzbar. Bei grobkörnigem Leuchtstoff (µm-Bereich) verringert die hohe Streuung die Effizienz. Ein konkreter Vorteil dieser gering dotierten Granate, - insbesondere Seltenerd-Granate, vor allem des Y, Gd, Lu, La, Tb und deren Mischungen als Kation A und Al und Ga oder deren Mischungen als Sauerstoffpartner B in der Formel AxByOz, vor allem A3B5O12, -- bei Anwendung in LEDs ist, dass damit jetzt erstmals im grünen Spektralbereich liegende Farborte erreicht werden können. Ein konkretes Beispiel ist YAG:Ce mit geringer Cer-Konzentration unter 1 mol%, die dazu führt, dass das Emissionsmaximum des Leuchtstoffs (Peak) sich zu kurzwelligen Wellenlängen hin verschiebt. Die grobkörnige ("µm") Variante dieses gering Ce-haltigen Leuchtstoffs kann wegen geringer Absorption, starker Streuung und damit verbundenen Strahlungsverlusten für LEDs nicht verwendet werden, nur die nano-Variante ist sinnvoll. Tendenziell sind hier also die nano-Varianten geeignet, den Farbort von rot in Richtung grün zu schieben, wobei die bestimmenden Parameter die Aktivatorkonzentration (meist Ce allein oder in Kombination mit anderen Seltenen Erden wie Pr) und die Korngröße des Leuchtstoffs sind. Ähnliches gilt auch für andere Seltene Erden-dotierte Leuchtstoffe, zum Beispiel Silikat- und Nitrid-Leuchtstoffe.

Eine besondere Variante ist der Zusatz von Wirtsgitterkomponenten (Komponente B des Aluminats oder Granats), die ebenfalls zu einer Verschiebung der Emission zu kurzen Wellenlängen hin, also ins Grüne, führen. Dabei kann die Aktivatorkonzentration im üblichen bisher bekannten Bereich liegen. Ein konkretes Beispiel ist die Zugabe von Gallium, insbesondere 5 bis zu circa 40 mol-% des Aluminium-Gitterplatzes) zum üblichen YAG:Ce (Aktivatorkonzentration 1 bis 4 mol% der Komponente A, also hier Yttrium), wodurch sich der spektrale Überlapp der Absorptionsbande des Ga-substituierten YAG:Ce mit der anregenden 460 nm- Strahlung der blauen LED und damit die Absorption verringert. Auch in diesem Fall ist beispielsweise nur die nano-Ausführung des Leuchtstoffs für LEDs, insbesondere weiße LEDs, mit blauer Primärstrahlung, Bereich 430 bis 470 nm, nutzbar.

Ein weitere bevorzugte Ausführungsform sind halbleitende Nanopartikel, wie beispielsweise ZnS und ZnSe. Bisher sind jedoch nur die undotierten und die Mndotierten Leuchtstoffe überhaupt als Nanopartikel hergestellt worden. Diese bisher bekannte Dotierung, einzig Mn, für Nanopartikel ist jedoch für ganz andere Zwecke gedacht, siehe EP 622 439. Bekannte Dotierungen für makroskopische Partikel (im µm-Bereich) sind u.a. Al, Cu, Ag, Mn. Erstmals wird hier die Verwendung derartiger Nanopartikel, die mit Mn, Al, Cu, Ag und/oder Cu dotiert sind, für LEDs, insbesondere weiße LEDs, vorzugsweise mit blauer oder UV-Primärstrahlung im Bereich 300 bis 470 nm, vorgeschlagen. Diese Nanopartikel lassen sich je nach Partikelgröße und Dotierung auf eine Absorption im Blauen und UV gezielt einstellen. Allgemein sind Halbleiter des Typs II-VI wie (Cd,Zn)(Se,Te,S) geeignet. Diese Art von Leuchtstoff, vor allem CdSe ist eine hocheffiziente Alternative zu dem üblichen gelb emittierenden YAG:Ce oder TbAG:Ce. Eine Alternative ist ein III-IV-Halbleiter. Der besondere Vorteil der halbleitenden nano-Leuchtstoffe ist, dass sie eine schmalbandige Emission mit einer Halbwertsbreite (FWHM) von typisch 30 nm haben.

Die Absorption setzt bei undotierten halbleitenden Nano-Leuchtstoffen etwa bei der Bandkante ein, ist also nur durch eine geringe Stokes-Verschiebung von der Emission getrennt. Bei einem Mehr-Komponenten Leuchtstoff-System absorbiert jedoch normalerweise der Rot-Leuchtstoff stark die Emission des Grün-Leuchtstoffs etc. Zur Vermeidung dieser gegenseitigen Absorption der Halbleiter-nano-Leuchtstoffe sind deshalb Leuchtstoffsysteme bevorzugt, bei denen entweder nur ein einziger undotierter nano-Halbleiter-Leuchtstoff in Kombination mit der anregenden LED verwendet wird, oder bei Verwendung mehrerer nano-Leuchtstoffe nur der kurzwellig emittierende ein undotierter halbleitender nano-Leuchtstoff ist. Äquivalent gilt diese Überlegung auch für solche Kombinationen von anregender LED-Primärstrahlung und dotierten halbleitenden nano-Leuchtstoffen, wenn die Absorption der LED-Strahlung nicht über den Aktivator sondern im Wirtsgitter bei Energien größer der Bandlücke des Halbleitermaterials erfolgt.

Ein Beispiel für ein Ein-Komponenten-System ist eine blau bis grün emittierende Primärstrahlung der LED (430 bis 480 nm), die mit einem gelb bis orangerot emittierenden Nano-Leuchtstoff geringer Halbwertsbreite kombiniert wird, insbesondere CdSe.

Meist ist der Leuchtstoff in einem Verguss dispergiert ist, der der primären Strahlung ausgesetzt ist. Der Verguss ist bevorzugt Epoxidharz oder Silikon oder ein ähnliches anderes Vergussmittel.

Weitere Medien, in die der nanoskalige Leuchtstoff eingebracht werden kann, sind: Harz, Luft, Flüssigkeiten mit hohem Brechungsindex (ähnlich wie bei Okularen von Mikroskopen), Zeolithe oder andere nano-poröse Medien, Kunststoffe, Glas. Eine besonders bevorzugte, elegante Methode ist, die Oberfläche des Halbleiterchips durch Ätzen nanoporös zu machen und die nano-Leuchtstoffe in die Porositäten einzubringen.

Zur Definition der Begriffe "transparent" und "reduzierte Streuung" wird der Materialverbund aus nano-Leuchtstoff(en) und einem nicht-absorbierenden Medium betrachtet, das "nano-Leuchtstoff-Material". Für ein solches nano-Leuchtstoff-Material ist die gerichtete Transmission bei einem Einfallswinkel kleiner 10° und bei einer Wellenlänge, bei welcher der nano-Leuchtstoff und damit das nano-Leuchtstoff-Material nur vernachlässigbar absorbieren, größer als 80%. Eine geeignete Wellenlänge für diesen Test ist zum Beispiel 10 nm langwelliger als diejenige Wellenlänge auf der langweiligen Seite der Emissionsbande des Leuchtstoffs, bei der die Emission auf 1 % des Maximalwertes abgesunken ist.

Die Herstellung von nano-Leuchtstoffen erfolgt bevorzugt mittels CVR/CVD direkt auf den Chip. Insbesondere Granate wie YAG sind für diese Aufbringungsart besonders geeignet. Hierzu eignet sich vor allem das Prinzip des "waver-level coating" mit nano-Leuchtstoffen. Dabei ist es möglich die Leuchtstoffschicht direkt auf den Chip aufzubringen (beispielsweise kompatibel mit ink jet, CVD u.ä.). Nanoleuchtstoffe eignen sich sehr gut zum sog. waver level coating, da sich spin-on-Verfahren verwenden lassen. Bei partikelgefüllten Beschichtungsmassen, also großen Durchmessern im Bereich von µm, verhindert die Fliehkraft eine gleichmäßige Beschichtung. Diese ist jetzt möglich infolge der Verwendung nanoskaliger Partikelgrößen, im Bereich von insbesondere 1 bis 50 nm.

### Kurze Beschreibung der Zeichnungen

Im folgenden soll die Erfindung anhand mehrerer Ausführungsbeispiele näher erläutert werden. Es zeigen:
- Figur 1: eine LED, im Schnitt;
- Figur 2: eine Darstellung des Prinzips der Farbortverschiebung im CIE-Diagramm (Fig. 2a), insbesondere bei einem schwach absorbierenden Leuchtstoff (Figur 2b) und modifizierten Leuchtstoff (Figur 2c);
- Figur 3: eine Darstellung des Prinzips der verringerten Absorption eines modifizierten Leuchtstoffs;
- Figur 4: eine Darstellung des Prinzips der verschobenen Emission eines modifizierten Leuchtstoffs;
- Figur 5: eine Darstellung der Farbortverschiebung bei geringer Ce-Konzentration für YAG:Ce und bei Zugabe von Ga zu Al im System YAG:Ce ;
- Figur 6: eine Darstellung des Prinzips der schwachen Absorption im Hinblick auf die Emission der Primärstrahlung;
- Figur 7: eine Darstellung des Prinzips der Emission eines Halbleiterleuchtstoffs.

### Bevorzugte Ausführung der Erfindung

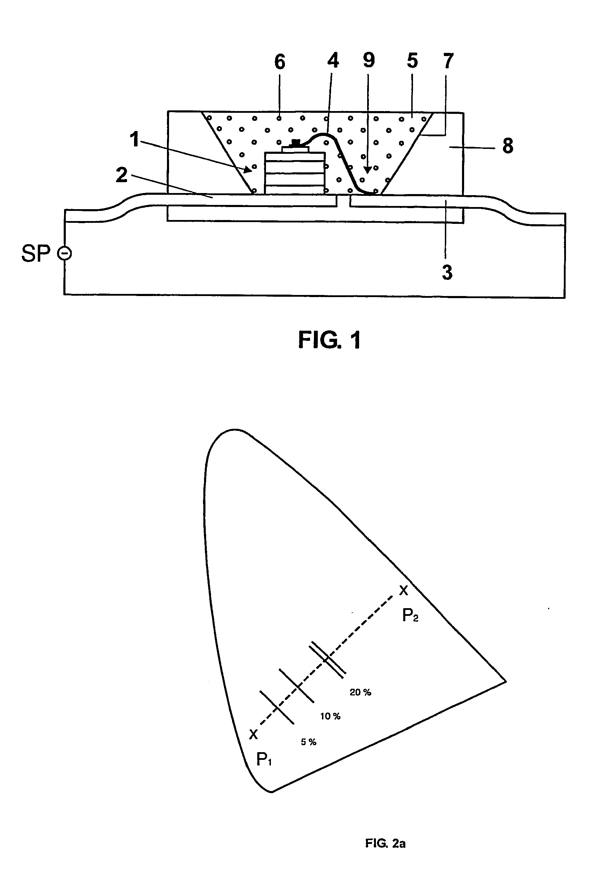

Für den Einsatz in einer weißen LED, die nach dem Lukoled-Prinzip arbeitet, zusammen mit einem InGaN-Chip wird beispielsweise ein Aufbau ähnlich wie in US 5 998 925 beschrieben verwendet. Der Aufbau einer derartigen Lichtquelle für weißes Licht ist in Figur 1 explizit gezeigt. Die primäre Lichtquelle ist ein Halbleiterbauelement (Chip 1) des Typs InGaN mit einer Peak-Emissionswellenlänge von 460 nm mit einem am Chip endenden ersten und zweiten elektrischen Anschluss 2, 3, das in ein lichtundurchlässiges Grundgehäuse 8 im Bereich einer Ausnehmung 9 eingebettet ist. Einer der Anschlüsse 3 ist über einen Bonddraht 4 mit dem Chip 1 verbunden. Die Ausnehmung hat eine Wand 7, die als Reflektor für die blaue Primärstrahlung des Chips 1 dient. Die Ausnehmung 9 ist mit einer nichtleitenden Vergussmasse 5 gefüllt, die als Hauptbestandteile ein Polymer, Silikon oder auch Epoxidgießharz (80 bis 90 Gew.-%), und Leuchtstoffpigmente 6 (weniger als 15 Gew.-%) enthält. Eine derartige Diode wird mit einer Spannung von typisch 3 V betrieben. Die Spannung wird von einer Spannungsquelle SP an die Anschlüsse 2,3, vermittelt.

Als photolumineszierender nano-Leuchtstoff für eine primär blau emittierende LED eignen sich insbesondere YAG:Ce, insbesondere mit niedriger Cer-Konzentration von 0,1 bis 0,6 mol-%, und Y3(AlxGay)5O12:Ce, insbesondere mit relativ hoher Cer-Konzentration von 1 bis 5 mol%, wobei x+y =1 und y = bevorzugt 0,1 bis 0,5. Insbesondere eignet sich der Leuchtstoff Y3(Al0,6Ga0,4)5O12:Ce.

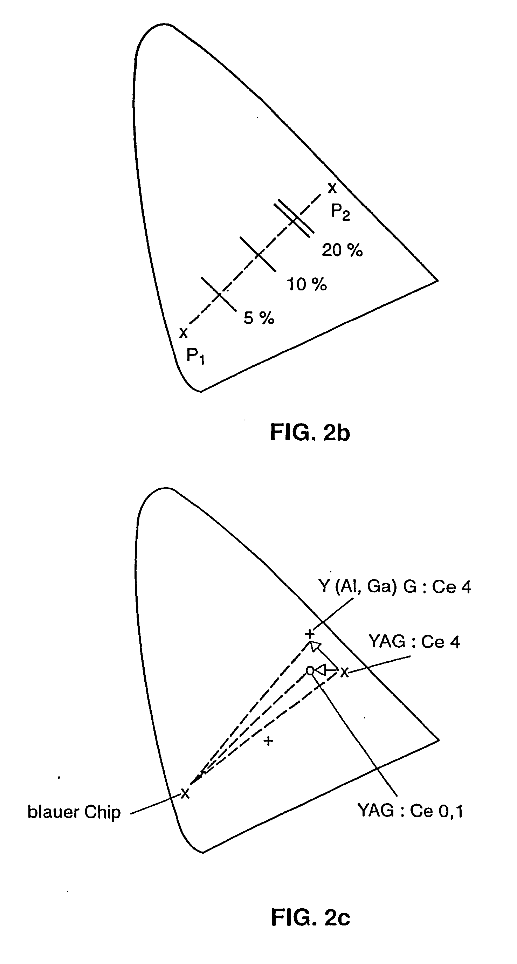

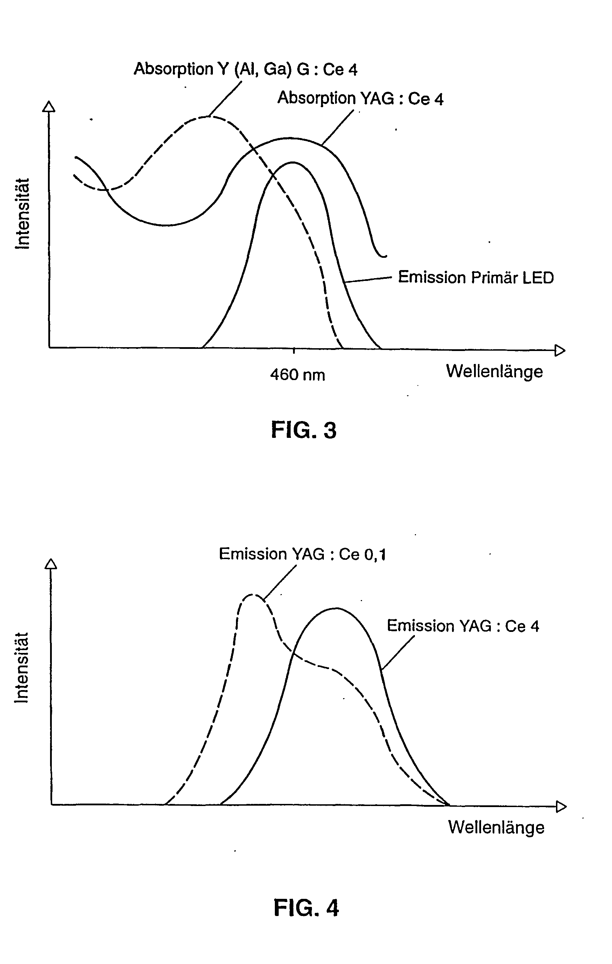

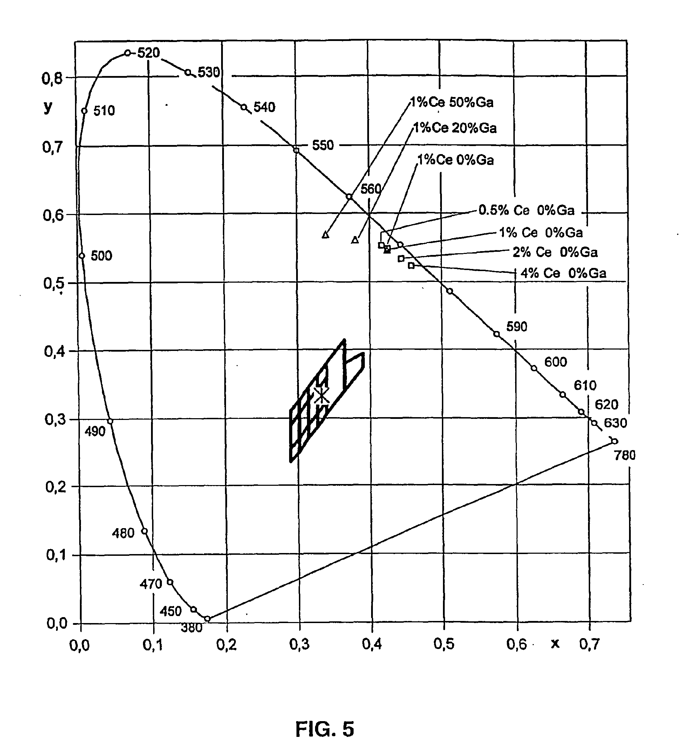

Bei diesen Leuchtstoffen ist häufig der Farbort deutlich grüner als der von bisher verwendetem YAG:Ce. Die Absorption des Ga-haltigen Granats verschiebt sich beispielsweise in Richtung kurzer Wellenlänge, siehe Fig. 3 als Prinzip. Sie kann sich soweit verschieben, dass der Punkt A =50 % in der Absorptionskurve unterhalb der Peakwellenlänge von 460 nm der Primäremission liegt, siehe Fig. 2c als Prinzipskizze und die detaillierten Angaben in Fig. 5. Dieser Leuchtstofftyp wird hier als einziger nano-Leuchtstoff zusammen mit einem InGaN-Chip verwendet. Seine µm-Variante ist dagegen nicht für LED-Anwendungen nutzbar.

Ein ähnlicher Sachverhalt liegt bei Verwendung geringer Konzentrationen des Aktivators vor. Bei YAG:Ce mit geringer Aktivatorkonzentration (beispielsweise 0,1 bis 0,5 mol-% Ce als Anteil der Komponente Y) und ähnlichen Systemen liegt der Farbort der Emission des Leuchtstoffs deutlich mehr im grünen Bereich als bei hoher Cer-Konzentration (2 bis 4 mol-%), siehe Prinzip gemäß Figur 2c. die Verschiebung der Emission zu kürzeren Wellenlängen ist im Prinzip in Figur 4 dargestellt. Detailliert ist dieser Sachverhalt ebenfalls in der Farbortverschiebung in Fig. 5 dargestellt. Auch hier verschiebt sich die Absorptionskurve zu kürzeren Wellenlängen hin, so dass bei gegebenem Emissionsspektrum des Chips die Absorption des Leuchtstoffs reduziert ist. Dieses Verhalten, das nur vorteilhaft bei Verwendung von nanoskaligen Leuchtstoffen ausgenutzt werden kann, wird insbesondere bei einer Vielzahl von Granaten, die insbesondere mit Seltenen Erden (vor allem Ce, Eu, Pr und/oder Tb) dotiert sind, beobachtet. Als Konstituenten des Wirtsgitters A3B5O12 kommen insbesondere für Komponente A Y, La, Lu, Gd, Tb einerseits und für Komponente B Al, Ga und In in Frage.

Die mittlere Partikelgröße d₅₀ des nano-Leuchtstoffs liegt bevorzugt bei etwa 5 bis 10 nm. Derartige Nano-Leuchtstoffe minimieren die Streuung der anregenden blauen Strahlung. Damit steigt die Effizienz infolge Verringerung der Streuung und Reflexionsverluste an der Gehäusewand. Hier sind insbesondere schwach absorbierende Leuchtstoffe anwendbar. Dabei sind die Leuchtstoffpartikel über die Harzsuspension homogen verteilt. Es tritt keine Sedimentation auf.

Als Leuchtstoff für eine UV-emittierende LED eignen sich insbesondere die o.e. RGB-Kombiantionen von drei nano-Leuchtstoffen, beispielsweise eine Kombination von SCAP (blau), ein Cu-dotiertes ZnS:Cu oder Sr4AI14O25:Eu (grün) und Sr-Nitrid oder ein Oxisulfid (rot).

Vor allem bei dieser Variante (UV) macht sich besonders vorteilhaft der jetzt infolge der Verwendung von nano-Leuchtstoffen mögliche lange Absorptionsweg bemerkbar. Durch den langen Weg wird verhindert, dass UV-Strahlung die Zone der Konversion verlässt und somit die Umgebung, insbesondere das Gehäuse, beschädigt. Besonders bevorzugt ist daher eine Schichtdicke des den Leuchtstoff enthaltenden Harzes oder Vergusses, die sicherstellt, dass vorteilhaft nicht mehr als 5 % der ursprünglichen UV-Strahlung ungehindert - wobei also mindestens 95% ursprünglichen UV-Strahlung absorbiert oder gestreut werden- , die Konversionszone verlassen. Die Extinktion soll also bei mindestens 80%, bevorzugt mindestens 90 %, besonders bevorzugt mindestens 95% liegen für eine Primärstrahlung, deren PeakWellenlänge im Bereich 330 bis 410 nm liegt. Bei UV-LEDs tritt im Gegensatz zu einer blauen LED kein Problem einer Punktlichtquelle auf. Bevorzugte Realisierungen sind entweder RGB-Lösungen oder BY (blau-gelb)-Lösungen.

Ein besonderer Vorteil von Nano-Leuchtstoffen ist eine vereinfachte Aufbringung auf den Chip. Sie eignen sich für das sog. On-Chip-Coating. Im einzelnen läuft dieses folgendermaßen ab:

Aufschleudern oder auch Spin Coating: Es wird eine kleine Flüssigkeitsmenge auf einen rotierenden Wafer aufgetropft. Durch die Rotation kommt es zu einer gleichmäßigen Schichtbildung (Standardverfahren zum Aufbringen von Photolacken in der Halbleiterindustrie). Bei Verwendung von Leuchtstoffpartikeln kommt es wegen den Fliehkräften zu einer Entmischung. Dies ist bei Nanopartikeln nicht der Fall.

Bei Inkjet-Verfahren ist eine gleichmäßige und strukturierte Aufbringung von Nanoleuchtstoffen in geeigneten Bindern möglich.

Nano-Leuchtstoffe können in Lösung stabil gehalten werden und eigenen sich daher auch für Aufbringverfahren mittels Ink-Jet, Spin-Coating oder auch Photo-Resist Technologien.

Halbleitende Nano-Leuchtstoffe wie beispielsweise (Zn,Cd)(S,Se,Te) absorbieren vorteilhaft direkt oberhalb der Bandlücke, wobei eine starke Absorption unter allen Umständen vorliegt.

Allgemein lassen sich Seltene Erden-dotierte Nano-Leuchtstoffe mittels CVR synthetisieren. Dieser neue Prozess ist kompatibel mit bekannten CVD-Prozessen. Er stellt ein alternatives Beschichtungsverfahren dar. Es ist dabei kein Binder als Matrix nötig.

In einem besonders bevorzugten Ausführungsbeispiel ist die mittlere Partikelgröße d50 des Leuchtstoffs jeweils so gewählt, dass er einem Minimum der Reflexion dieses Leuchtstoffs, bezogen auf die Peakwellenlänge der Primärstrahlung entspricht. In diesem Sinne sind also LED und Leuchtstoffe ein abgestimmtes System, wobei im Falle mehrerer Leuchtstoffe deren Partikelgröße d50 unterschiedlich zu wählen ist. vorteilhaft wird für eine gegeben Peakwellenlänge der LED ein möglichst großer mittlerer Durchmesser des zugeordneten Leuchtstoffs gewählt, weil die Herstellung dann einfacher ist.

Des weiteren sind auch Systeme möglich, bei denen eine konventionelle Leuchtstoff-Komponente und eine Halbleiterkomponente zusammen verwendet werden. Ein besonders bevorzugtes Ausführungsbeispiel ist eine UV-LED mit RGB-Konversion, unter Verwendung einer RGB-Kombination, für Rot: Y2O2S:Eu+, für Grün (ZnS:Cu,Al oder ZnS:Cu,Mn oder ZnS:Cu), wobei diese Leuchtstoffe Halbleiterkomponenten sind, und für Blau (SCAP oder ZnS:Ag), wobei beispielsweise SCAP ein anorganischer dotierter konventioneller Leuchtstoff ist.

Ein bevorzugtes spezielles Verguss-Systeme für Nano-Leuchtstoffe ist Silikon. Denn Silikone sind besonders alterungsstabile Vergussmassen für Emitter im nahen UV- und Blau-Spektralbereich.

Eine besonders bevorzugte Ausführungsbeispiel ist ein System, bei dem der Chip selbst geeignet strukturiert ist, um Nano-Leuchtstoffe aufzunehmen. Dazu kann der Chip an seiner Oberfläche angeätzt werden, so dass er eine Porosität besitzt, in die die Nanomaterialien eindringen können. Der Vorteil dieser Lösung ist, dass dadurch die Reflexionsverluste noch weiter erniedrigt werden können.

Konkrete Beispiele von Leuchtstoffen, die die anregende Strahlung einer UV-LED mit 380-410 nm Primäremission nur am Rande der Absorptionskante und damit schwach absorbieren, die also bisher nicht für LED-Anwendungen genutzt werden konnten, aber als nano-Leuchtstoffe nutzbar sind, sind Sulfate, Borate und Apatite.

Eine andere Gruppe von Leuchtstoffen, die gut absorbieren, bei denen es aber auf die Gleichmäßigkeit der Lichtabstrahlung ankommt, die durch die Nano-Konfiguration erzielt wird, sind Granate, Thiogallate und Chlorosilikate.

In Fig. 2a und 2b ist für einen Leuchtstoff mit geringer Aktivatorkonzentration die Erzielbarkeit neuer Farborte schematisch illustriert. Es handelt sich beispielsweise um eine InGaN-LED, die blau emittiert (beispielsweise 460 nm Peakemission), siehe Farbort P1, und die einmal mit einem konventionellen Leuchtstoff YAG:Ce (dessen theoretischer eigener Farbort mit P2 markiert ist) kombiniert ist (Figur 2a) sowie mit einem nano-Leuchtstoff YAG:Ce mit gleicher Ce-Konzentration (Figur 2b). Beide Leuchtstoffe verwenden 0,1 bis 0,5 mol-% Ce, und der Anteil am Harz ist jeweils zwischen 5 und bis zu 20 Gew.-% gewählt. Die reduzierte Streuung über einen langen Weg führt nun dazu, dass der resultierende Farbort bei hoher Beimengung des Leuchtstoffs (10 und 20 %) wesentlich näher beim theoretischen Farbort P2 des YAG:Ce liegt. In Figur 2a verdeutlich die kurze Strecke bis zum Farbort der 20 %i-gen Beimischung den wegen der hohen Absorption nur geringen nutzbaren Farbort-Bereich (bis maximal 20 % Harzanteil) der µm-Variante auf der Verbindungslinie zwischen den Farborten der LED-Primäremission P1 und dem des Leuchtstoffs P2. Dagegen verdeutlicht die wesentlich längere Strecke in Figur 2b bis zum dortigen Farbort der 20 %igen Beimischung den vergrößerten nutzbaren Bereich bei Verwendung des nano-Leuchtstoffs. Detaillierte Farborte für YAG:Ce mit unterschiedlicher Cer-Konzentration sind in Fig. 5 für reines YAG:Ce (ohne Ga, dort als 0 %Ga bezeichnet) und mit teilweisem Ersatz des Al durch Ga (dort als 20 %Ga und 50 % Ga bezeichnet) dargestellt. Ein Weiß-Bereich um den Weißpunkt 0,333/0,333 ist ebenfalls dargestellt. Derartige nano-Leuchtstoffe ermöglichen also eine Zugangsmöglichkeit zu Farborten mit x ≥ 0,35 und/oder y ≥ 0,35, insbesondere auch farbige Farborte mit x ≥ 0,40 und/oder y ≥ 0,40.

In Fig. 2c ist als Prinzipdarstellung zeigt, dass der Ersatz von 40 mol-% des Aluminium durch Ga dazu führt, dass der Farbort nach rechts im CIE-Diagramm, also zu grüneren Farborten hin wandert unter Beibehaltung des Vorteils der besseren Erreichbarkeit des theoretischen Farborts, ähnlich wie bei Fig. 2b gezeigt.

Ein geeignet gewählter nano-YAG:Ce mit verringertem Aktivatorgehalt zeigt eine gleichbleibend hohe Quanteneffizienz unabhängig von der Dicke der Vergussmasse. Dieses Verhalten ermöglicht erstmals völlig neue geometrische Ausführungsformen wie beispielsweise extrem flache LED-Bauelemente.

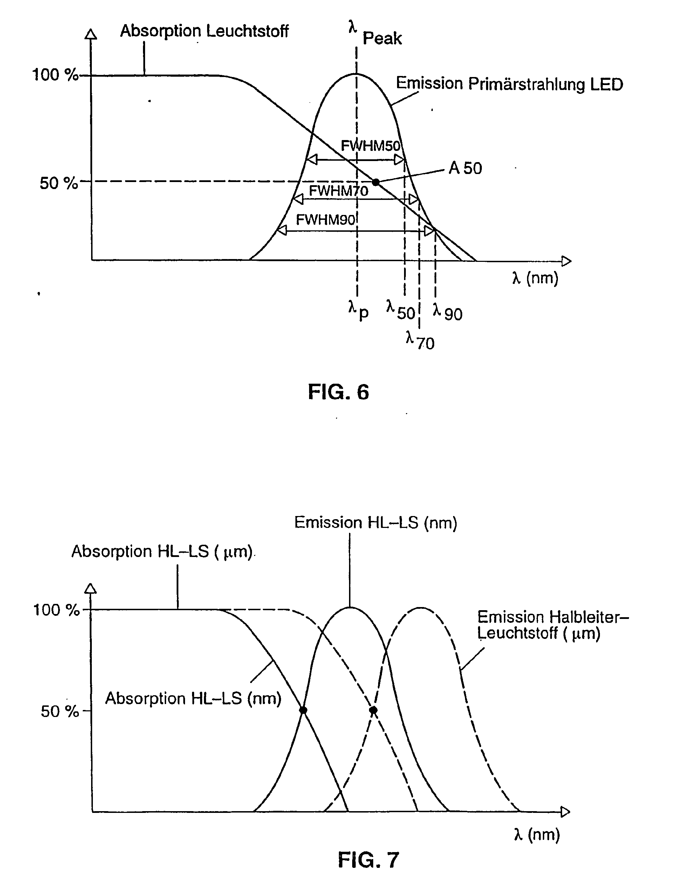

Eine wesentliche Konsequenz des oben gesagten ist darin zu sehen, dass durch Wahl der nanoskaligen Partikelgröße eine neue Klasse von Leuchtstoffen für die Verwendung bei LEDs erschlossen werden kann, bei der die Absorptionskante, beschrieben durch den A50-Punkt, an dem die Absorption des Leuchtstoffs nur noch 50 % der maximalen Absorption beträgt, deutlich kurzwelliger liegt als die langwellige Kante der Primäremission des Chips. Beispielsweise sind jetzt Leuchtstoffe mit hoher Effizienz gut nutzbar, deren A50 Punkt unterhalb der langweiligen Schwelle einer Emissionsintensität von 10 % der Peakemission λpeak liegt, siehe Fig. 6. Diese langwellige Kante λ90 der Primäremission, die zur 90 %-Breite "FWHM 90" der primären Emission gehört, liegt im allgemeinen ca. 10 bis 15 nm (beispielsweise 475 nm) oberhalb der Peakemission (beispielsweise bei λp = 460 nm). Diese Nutzbarkeit ist erstaunlicherweise sogar noch dann in vielen Fällen gegeben, wenn der Punkt A50 unter der zum langweiligen Kantenpunkt "FWHM 70" gehörenden Wellenlänge λ70, insbesondere sogar unterhalb der zum langwelligen Kantenpunkt "FWHM 50" gehörenden Wellenlänge λ50 liegt, siehe Fig. 6. Sogar ein Wert von A50 unterhalb der Wellenlänge λp der Peakemission ist jetzt nutzbar. Diese Lehre steht im völligen Gegensatz zur bisherigen Philosophie einer möglichst guten Überdeckung zwischen Primäremission und Absorptionskurve des konvertierenden Leuchtstoffs, wie sie in US 5 998 925 dargelegt ist.

In einer weiteren bevorzugten Ausführungsform wird der Nano-Leuchtstoff auf Basis von Halbleitern mit einer Beschichtung versehen, die ein Zusammenklumpen (Agglomeration) des Pulvers verhindert, wie an sich bekannt, siehe Einleitung.

Ein besonderer Vorteil der Nano-Leuchtstoffe ist ihre leichte Verarbeitbarkeit, so dass man nicht mehr auf komplizierte Gussharz-Systeme angewiesen ist, sondern eine schnelle Verarbeitung mittels Drucken, Spritzen oder Ink-Jet einsetzen kann. Die Kleinheit der Leuchtstoff-Partikel führt jetzt dazu, dass keine abrasiven Effekte zu befürchten sind und Verstopfung feiner Düsen nicht auftritt. Die Prozessführung wird also wesentlich vereinfacht.

Leuchtstoffe mit harten Partikeln wie beispielsweise Granate schränken die Material- und Verfahrenswahl beim Dosieren ein. Bei Granaten, die mittels Spindeldosierern eingebracht werden, konnten bisher keine üblichen Werkzeugstähle verwendet werden, sondern es wurde Hartmetall für Spindel und Führung verwandt. Bei Verwendung von nano-Leuchtstoff entfällt diese Einschränkung. Eine weitere Vereinfachung ergibt sich bzgl. der Verfahrenswahl. Es kommen auch ink-jet-Verfahren für kleine Mengen und strukturierte Aufbringung in Frage.

Die Herstellung von Nano-Leuchtstoffpartikeln ist in der Literatur breit beschrieben. Übliche Verfahren basieren auf CVD, Sol-Gel-Techniken oder Fällung.

Der besondere Vorteil von Halbleiter-Leuchtstoffen wie CdSe ist, dass die Bandlücke durch die Partikelgröße eingestellt werden kann. Das Prinzip ist in Fig. 7 dargestellt. Für eine bestimmte anregende Peakwellenlänge, die möglichst schmalbandig sein sollte, bevorzugt ist eine typische Halbwertsbreite kleiner als 20 nm, bevorzugt 10 nm, ist es dabei so, dass die Emission des Halbleiter-Leuchtstoffs (HL-LS) mit kleinerem Partikeldurchmesser zu kürzeren Wellenlängen wandert, da die Absorption der Primärstrahlung durch den Halbleiter-Leuchtstoff ebenfalls zu kürzeren Wellenlänge n hin verschoben wird, und gleichzeitig die Absorption und Emission über eine feste Beziehung (50 %-Regel) miteinander gekoppelt ist.

Bevorzugt wird bei halbleitenden Leuchtstoffen ein weiß emittierendes gesamtes System bestehend aus einer blau emittierenden Primärlichtquelle und einem einzigen gelb emittierenden Leuchtstoff eingesetzt. Alternativ wird eine blaugrüne Primärlichtquelle mit einem roten Leuchtstoff kombiniert. Ein Beispiel ist ein InGaN-Chip mit einer Peakwellenlänge von 485 nm und ein nano-Leuchtstoff vom Typ (Ca,Ba,Sr)-Nitrid wie beispielsweise in EP 1 153 101 beschrieben.

Anmerkung: FW bedeutet: full width, also volle Breite, siehe Figur 6. FWHM bedeutet: volle Breite bei halbem Maximum, also FW50.

Die Konversion der primären Strahlung des Chips in sekundäre vom Leuchtstoff emittierte Strahlung geht mit einer Differenz der Peakwellenlänge beider Strahlungen von mindestens 20 nm, typisch mindestens 50 nm, häufig auch mindestens 100 nm, einher.

## Patentansprüche

1. Lumineszenzkonversions-LED, wobei ein LED-Chip primäre Strahlung mit einer Peakwellenlänge im Bereich 300 bis 470 nm emittiert, wobei diese Strahlung teilweise oder vollständig durch Photolumineszenz in sekundäre längerwellige Strahlung konvertiert wird durch mindestens einen Leuchtstoff, der der primären Strahlung der LED ausgesetzt ist und der in ein Medium eingebracht ist, **dadurch gekennzeichnet, dass** zur Erhöhung der Effizienz die Konversion zumindest unter Zuhilfenahme eines Leuchtstoffs, der im folgenden als nano-Leuchtstoff bezeichnet wird, erreicht wird, dessen mittlere Partikelgröße d₅₀ im Bereich 1 bis 50 nm, bevorzugt ist d₅₀ 2 bis 25 nm, liegt.

2. LED nach Anspruch 1, **dadurch gekennzeichnet, dass** der Leuchtstoff in einem Verguss dispergiert ist, der der primären Strahlung ausgesetzt ist, wobei dieser Verguss aus isolierendem Material besteht.

3. LED nach Anspruch 1, **dadurch gekennzeichnet, dass** eine blau emittierende Primärstrahlung der Peakwellenlänge 420 bis 470 nm verwendet wird, zusammen mit einem sekundär gelb emittierenden Leuchtstoff.

4. LED nach Anspruch 1, **dadurch gekennzeichnet, dass** eine UV-emittierende Primärstrählung der Peakwellenlänge 330 bis 410 nm verwendet, zusammen mit drei Leuchtstoffen, die sekundär rot, grün und blau emittieren.

5. LED nach Anspruch 4, **dadurch gekennzeichnet, dass** folgendes Leuchtstoffsystem verwendet wird: für Rot: Y2O2S:Eu; und für Grün: ZnS:Cu,Al oder ZnS:Cu,Mn oder ZnS:Cu; und für Blau: SCAP oder ZnS:Ag.

6. LED nach Anspruch 1, **dadurch gekennzeichnet, dass** der Leuchtstoff so gewählt ist, dass er im Bereich der Peakwellenlänge der Primärstrahlung nur schwach absorbiert und insbesondere ein Leuchtstoff ist, dessen Lumineszenz durch einen Aktivator bewirkt ist.

7. LED nach Anspruch 6, **dadurch gekennzeichnet, dass** ein nano-Leuchtstoff so gewählt ist, dass ein gleichartiger, aber grobkörniger Leuchtstoff, der im folgenden als µm-Leuchtstoff bezeichnet ist, bei der Peakwellenlänge des LED-Chips eine Reflexion größer 50% zeigt, wenn eine Reflexionsmessung an einer gepressten Pulvertablette durchgeführt wird, die aus dem µm-Leuchtstoff besteht und die optisch dicht ist, das heißt eine winkelintegrierte Transmission < 5% aufweist, wobei grobkörnig bedeutet, daß die mittlere Partikelgröße d50 größer als 1 µm ist, insbesondere ist d50 ≤ 20 µm, bevorzugt d50 ≤ 10 µm.

8. LED nach Anspruch 6, **dadurch gekennzeichnet, dass** die langwellige Absorptionskante des nano-Leuchtstoffs, die beschrieben ist durch den Punkt A50, unterhalb der langwelligen Kante der Primäremission, beschrieben durch den langwelligen Punkt FW 90, bevorzugt FW 70, besonders bevorzugt durch FW 50, höchst bevorzugt durch die Peakwellenlänge selbst, liegt.

9. LED nach Anspruch 7, **dadurch gekennzeichnet, dass** ein nano-Leuchtstoff mit Aktivator verwendet wird, der so gewählt ist, dass die Konzentration des Aktivators niedrig ist, und zwar höchstens 75 %, bevorzugt 10 bis 50 %, der Konzentration des Aktivators bei dem gleichartigen µm-Leuchtstoff erreicht, so dass die gegebene Aktivatorkonzentration des µm-Leuchtstoffs höher ist und als Bezugsgröße entsprechend 100 % dient, wobei der µm-Leuchtstoff so gewählt ist, dass er im Bereich der Peakwellenlänge der Primärstrahlung stark, bevorzugt zu mehr als 50 %, insbesondere zu mehr als 70% absorbiert, jedoch ein gleichartiger Leuchtstoff mit niedriger Konzentration des Aktivators im Bereich der Peakwellenlänge der Primärstrahlung schwach absorbiert, bevorzugt höchstens 30 %, insbesondere höchstens 20 %.

10. LED nach Anspruch 1, **dadurch gekennzeichnet, dass** ein einziger Leuchtstoff verwendet wird, der aus halbleitenden Nanopartikeln besteht, insbesondere CdSe.

11. LED nach Anspruch 1, **dadurch gekennzeichnet, dass** der Chip über elektrisch leitende Anschlüsse mit einer Spannungsquelle verbunden werden kann.

12. LED nach Anspruch 11, **dadurch gekennzeichnet, dass** die Spannungsquelle eine Spannung von maximal 5 V vermittelt.

13. LED nach Anspruch 9, **dadurch gekennzeichnet, dass** der nano-Leuchtstoff ein Granat A3B5O12 ist, der mit einem Seltenerdelement D dotiert ist, wobei der Anteil des D höchstens 0,9 mol-% von A ist.

14. Herstellung von LEDs mit nano-Leuchtstoffen gemäß einem der vorhergehenden Ansprüche, wobei der Leuchtstoff mittels CVR oder CVD direkt auf den Chip aufgebracht wird.

15. Herstellung von LEDs mit nano-Leuchtstoffen gemäß einem der vorhergehenden Ansprüche, wobei der Leuchtstoff mittels Drucken, Spritzen oder Ink-Jet auf den Chip aufgebracht wird.

16. Verwendung von Nanoleuchtstoffen mit einer mittleren Partikelgröße d₅₀ von 1 bis 50 nm als Konversionsmittel in optischen Halbleiterbauelementen des Typs Lukoled zur Konversion von kurzwelliger primär emittierter Strahlung zwischen 300 und 470 nm in längerwellige Strahlung, insbesondere in sichtbare Strahlung im Bereich 430 bis 750 nm.

## Claims

1. Luminescence-conversion LED, an LED chip emitting primary radiation with a peak wavelength in the range of 300 to 470 nm, this radiation being converted partly or completely into secondary longer-wave radiation via photoluminescence by at least one phosphor which is exposed to the primary radiation of the LED and which is introduced into a medium, **characterized in that**, in order to increase the efficiency, the conversion is achieved at least with the assistance of a phosphor of a mean particle size d₅₀ that lies in the range of 1 to 50 nm, preferably 2 to 25 nm, which is referred to hereafter as a nanophosphor.

2. LED according to Claim 1, **characterized in that** the phosphor is dispersed in an encapsulating compound which is exposed to the primary radiation, this encapsulating compound comprising isolating material.

3. LED according to Claim 1, **characterized in that** a blue emitting primary radiation of a peak wavelength of 420 to 470 nm is used, together with a secondary yellow emitting phosphor.

4. LED according to Claim 1, **characterized in that** a UV emitting primary radiation of a peak wavelength of 330 to 410 nm is used, together with three phosphors which secondarily emit red, green and blue.

5. LED according to Claim 4, **characterized in that** the following phosphor system is used: for red: Y2O2S:Eu; and for green: ZnS: Cu,Al or ZnS:Cu,Mn or ZnS:Cu; and for blue SCAP or ZnS:Ag.

6. LED according to Claim 1, **characterized in that** the phosphor is chosen such that it has only low absorption in the range of the peak wavelength of the primary radiation and is in particular a phosphor that is made to luminesce by an activator.

7. LED according to Claim 6, **characterized in that** a nanophosphor is chosen such that an identical, but coarser-grained phosphor, which is referred to hereafter as a µm phosphor, exhibits at the peak wavelength of the LED chip a reflection of greater than 50% when a reflection measurement is carried out on a pressed powder tablet which consists of the µm phosphor and which is optically dense, that is to say has an angle-integrated transmission of < 5%, coarse-grained meaning that the mean particle size d50 is greater than 1 µm, in particular d50 is ≤ 20 µm, preferably d50 is ≤ 10 µm.

8. LED according to Claim 6, **characterized in that** the long-wave absorption edge of the nanophosphor, which is described by the point A50, lies under the long-wave edge of the primary emission, described by the long-wave point FW 90, preferably FW 70, particularly preferably by FW 50, extremely preferably by the peak wavelength itself.

9. LED according to Claim 7, **characterized in that** a nanophosphor with an activator is used, chosen such that the concentration of the activator is low, to be precise reaches at most 75%, preferably 10 to 50%, of the concentration of the activator in the case of the identical µm phosphor, so that the given activator concentration of the µm phosphor is higher and serves as a reference corresponding to 100%, the µm phosphor being chosen such that it has high absorption in the range of the peak wavelength of the primary radiation, preferably more than 50%, in particular more than 70%, but an identical phosphor with low concentration of the activator has low absorption in the range of the peak wavelength of the primary radiation, preferably at most 30%, in particular at most 20%.

10. LED according to Claim 1, **characterized in that** a single phosphor is used, comprising semiconducting nanoparticles, in particular CdSe.

11. LED according to Claim 1, **characterized in that** the chip can be connected to a voltage source by means of electrically conductive connections.

12. LED according to Claim 11, **characterized in that** the voltage source provides a voltage of 5 V at most.

13. LED according to Claim 9, **characterized in that** the nanophosphor is an A3B5012 garnet which is doped with a rare-earth element D, the proportion of D being, at most, 0.9 mol% of A.

14. Production of LEDs with nanophosphors according to one of the preceding claims, the phosphor being applied directly to the chip by means of CVR or CVD.

15. Production of LEDs with nanophosphors according to one of the preceding claims, the phosphor being applied to the chip by means of printing, spraying or ink-jet.

16. Use of nanophosphors with a mean particle size d50 of 1 to 50 nm as a conversion means in optical semiconductor devices of the LUCOLED type for the conversion of shortwave primary emitting radiation between 300 and 470 nm into longer-wave radiation, in particular into visible radiation in the range of 430 to 750 nm.

## Revendications

1. LED à conversion de luminescence, dans laquelle une puce LED émet un rayonnement primaire ayant une longueur d'onde de pic dans la plage 300 à 470 nm, lequel rayonnement étant converti, partiellement ou en totalité, par photoluminescence en rayonnement secondaire de longueur d'onde plus grande, grâce à au moins un luminophore exposé au rayonnement primaire de la LED et incorporé dans un milieu, **caractérisée en ce que**, de manière à accroître l'efficacité, la conversion est obtenue du moins à l'aide d'un luminophore, appelé ci-après nanoluminophore, dont la taille de particule moyenne d₅₀ se situe dans la plage 1 à 50 nm, d₅₀ étant de préférence comprise entre 2 et 25 nm.

2. LED selon la revendication 1, **caractérisée en ce que** le luminophore est dispersé dans un scellement exposé au rayonnement primaire, ledit scellement étant constitué d'un matériau isolant.

3. LED selon la revendication 1, **caractérisée en ce que** l'on utilise un rayonnement primaire émettant dans le bleu de longueur d'onde de pic 420 à 470 nm, ensemble avec un luminophore émettant un rayonnement secondaire dans le jaune.

4. LED selon la revendication 1, **caractérisée en ce que** l'on utilise un rayonnement primaire émettant des UV de longueur d'onde de pic 330 à 410 nm, ensemble avec trois luminophores émettant un rayonnement secondaire dans le rouge, le vert et le bleu.

5. LED selon la revendication 4, **caractérisée en ce que** l'on utilise le système de luminophore suivant: pour le rouge: Y202S:Eu ; et pour le vert: ZnS:CU,Al ou ZnS:Cu,Mn ou ZnS:Cu ; et pour le bleu: SCAP ou ZnS:Ag.

6. LED selon la revendication 1, **caractérisée en ce que** le luminophore est choisi de façon qu'il n'absorbe que faiblement dans la gamme de longueur d'onde de pic, et **en ce qu'**il est en particulier un luminophore dont la luminescence est provoquée par un activateur.

7. LED selon la revendication 6, **caractérisée en ce qu'**un nanoluminophore est choisi de façon qu'un luminophore de même nature mais à gros grain, appelé par la suite luminophore micronique, montre pour la longueur d'onde de pic de la puce LED une réflexion supérieure à 50% lorsque la réflexion est mesurée sur une pastille de poudre comprimée constituée dudit luminophore micronique et optiquement étanche, c'est-à-dire présente une transmission intégrée sur l'angle < 5%, où à gros grain signifie que la taille de particule moyenne d50 est supérieure à 1 µm, en particulier d50 ≤ 20 µm, de préférence d50 ≤ 10 µm.

8. LED selon la revendication 6, **caractérisée en ce que** l'arête d'absorption de grande longueur d'onde du nanoluminophore, décrite par le point A50, est située au-dessous de l'arête de grande longueur d'onde de l'émission primaire, décrite par le point de grande longueur d'onde FW 90, de préférence FW 70, d'une manière particulièrement préférée par FW 50, d'une manière tout particulièrement préférée par la longueur d'onde de pic elle-même.

9. LED selon la revendication 7, **caractérisée en ce que** l'on utilise un nanoluminophore contenant un activateur, et qui est choisi de façon que la concentration de l'activateur soit faible, c'est-à-dire qu'il atteigne au maximum 75%, de préférence 10 à 50%, de la concentration de l'activateur dans le luminophore micronique de même nature, de sorte que la concentration donnée de l'activateur du luminophore micronique est plus élevée et sert de quantité de référence correspondant à 100%, le luminophore micronique étant choisi de façon à absorber fortement dans la plage de la longueur d'onde de pic du rayonnement primaire, de préférence à raison de plus de 50%, en particulier de plus de 70%, mais de façon qu'un luminophore de même nature ayant une faible concentration de l'activateur absorbe faiblement dans la plage de la longueur d'onde de pic du rayonnement primaire, de préférence au maximum 30%, en particulier au maximum 20%.

10. LED selon la revendication 1, **caractérisée en ce que** l'on utilise un seul luminophore constitué de nanoparticules semiconductrices, en particulier CdSe.

11. LED selon la revendication 1, **caractérisée en ce que** la puce peut être connectée via des bornes électroconductrices à une source de tension.

12. LED selon la revendication 11, **caractérisée en ce que** la source de tension transmet une tension maximale de 5 V.

13. LED selon la revendication 9, **caractérisée en ce que** le nanoluminophore est un grenat A3B5012 dopé avec un élément de terres rares D, la proportion du D étant au maximum de 0,9 % en moles de A.

14. Fabrication de LED comprenant des nanoluminophores selon l'une des revendications précédentes, dans laquelle le luminophore est déposé directement sur la puce au moyen d'un procédé CVR ou CVD.

15. Fabrication de LED comprenant des nanoluminophores selon l'une des revendications précédentes, dans laquelle le luminophore est déposé sur la puce au moyen d'un procédé d'impression, de pulvérisation ou de jet d'encre.

16. Utilisation de nanoluminophores ayant une taille de particule moyenne d50 de 1 à 50 nm, comme moyen de conversion dans des composants semiconducteurs optiques du type Lukoled pour la conversion d'un rayonnement primaire de longueur d'onde courte comprise entre 300 et 470 nm en rayonnement de longueur d'onde plus grande, en particulier en rayonnement visible dans la gamme 430 à 750 nm.
